# EUROPEAN PATENT APPLICATION

(11) **EP 3 125 272 A1**
(43) Date of publication of application: **01.02.2017**
(21) Application number: 15178757.9
(22) Date of filing: 29.07.2015
(51) Int. Cl.: H01J 37/28

(54) **SCAN PATTERN IN A CHARGED PARTICLE MICROSCOPE COMPRISING NESTED ORBITAL WINDINGS**

(71) Applicant: FEI Company, Hillsboro, OR 97124-5793 (US)
(72) Inventor: Faber, Pybe, 5612 DV Eindhoven (NL)
(74) Representative: Bakker, Hendrik

(57) **Abstract**

A scanning-type Charged Particle Microscope, comprising:
- A specimen holder, for holding a specimen;
- A source, for producing a beam of charged particles;
- An illuminator, for directing said beam so as to irradiate the specimen;
- A detector, for detecting a flux of radiation emanating from the specimen in response to said irradiation;
- Scanning means, for producing relative scanning motion of the beam and specimen so as to cause the beam to trace out a scan path on the specimen;
- A programmable controller that can be invoked to execute at least one automated procedure in the microscope,
wherein:
- Said scan pattern comprises a sequence of nested orbital windings (W1-W6) about a central point of the pattern;
- A radius of said windings initially changes with a first sign (W1-W3) and subsequently changes with a second, opposite sign (W4-W6).

## Description

The invention relates to a method of using a scanning-type Charged Particle Microscope, comprising the following steps:
- Providing a specimen on a specimen holder;
- Directing a beam of charged particles from a source through an illuminator so as to irradiate the specimen;
- Using a detector to detect a flux of radiation emanating from the specimen in response to said irradiation;
- Using scanning means to produce relative scanning motion of the beam and specimen so as to cause the beam to trace out a scan pattern on the specimen.

The invention also relates to a scanning-type Charged Particle Microscope in which such a method can be enacted.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools *(e.g.* a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a specimen by a scanning electron beam precipitates emanation of "auxiliary" radiation from the specimen, in the form of secondary electrons, backscattered electrons, X-rays and photoluminescence (infrared, visible and/or ultraviolet photons), for example; one or more components of this flux of emanating radiation is/are then detected and used for image accumulation purposes.
- In a TEM, the electron beam used to irradiate the specimen is chosen to be of a high-enough energy to penetrate the specimen (which, to this end, will generally be thinner than in the case of a SEM specimen); the flux of transmitted electrons emanating from the specimen can then be used to create an image. When such a TEM is operated in scanning mode (thus becoming a STEM), the image in question will be accumulated during a scanning motion of the irradiating electron beam.

More information on some of the topics elucidated here can, for example, be gleaned from the following Wikipedia links:
http://en.wikipedia.org/wiki/Electron_microscope
http://en.wikipedia.org/wiki/Scanning_electron microscope
http://en.wikipedia.org/wiki/Transmission_electron_microscopy
http://en.wikipedia.org/wiki/Scanning_transmission_electron_microscopy

As an alternative to the use of electrons as irradiating beam, charged particle microscopy can also be performed using other species of charged particle. In this respect, the phrase "charged particle" should be broadly interpreted as encompassing electrons, positive ions (*e.g.* Ga or He ions), negative ions, protons and positrons, for instance. As regards non-electron-based charged particle microscopy, some further information can, for example, be gleaned from sources such as the following:
https://en.wikipedia.org/wiki/Focused_ion beam
http://en.wikipedia.org/wiki/Scanning_Helium Ion Microscope - W.H. Escovitz, T.R. Fox and R. Levi-Setti, Scanning Transmission Ion Microscope with a Field Ion Source, Proc. Nat. Acad. Sci. USA 72(5), pp 1826-1828 (1975).
http://www.ncbi.nlm.nih.gov/pubmed/22472444

It should be noted that, in addition to imaging and performing (localized) surface modification (*e.g.* milling, etching, deposition, *etc*.), a charged particle microscope may also have other functionalities, such as performing spectroscopy, examining diffractograms, *etc.*

In all cases, a scanning-type Charged Particle Microscope (CPM) will comprise at least the following components:
- A radiation source, such as a Schottky electron source or ion gun.
- An illuminator, which serves to manipulate a "raw" radiation beam from the source and perform upon it certain operations such as focusing, aberration mitigation, cropping (with an aperture), filtering, *etc.* It will generally comprise one or more (charged-particle) lenses, and may comprise other types of (particle-)optical component also. If desired, the illuminator can be provided with a deflector system that can be invoked to cause its output beam to perform a scanning motion across the specimen being investigated.
- A specimen holder, on which a specimen under investigation can be held and positioned (*e.g.* tilted, rotated). If desired, this holder can be moved so as to effect the desired scanning motion of the beam w.r.t. the specimen. In general, such a specimen holder will be connected to a positioning system such as a mechanical stage.
- A detector (for detecting radiation emanating from an irradiated specimen), which may be unitary or compound/distributed in nature, and which can take many different forms, depending on the radiation being detected. Examples include photomultipliers (including solid-state photomultipliers, SSPMs), photodiodes, CMOS detectors, CCD detectors, photovoltaic cells, X-ray detectors (such as SDD and Si(Li) detectors), *etc.,* which may, for example, be used in conjunction with a scintillator film, for instance.
- Scanning means, for producing relative scanning motion of the radiation beam and the specimen, thereby causing the beam to trace out a pre-determined (two-dimensional) scan pattern on (a presented surface of) the specimen. An image is then constructed on the basis of detector output per sampling point on the scan pattern, thus constructing a (two-dimensional) map of said specimen (surface). As alluded to above, such scanning means may, for example, be based on beam (scanning) deflection or holder (scanning) motion.
- A programmable controller (computer processor) for regulating operation of the microscope and/or executing control commands (*e.g.* as enshrined in software, generally supplemented/modified by input from a user interface and signals from sensors).
In what follows, the invention may - by way of example - sometimes be set forth in the specific context of electron microscopy. However, such simplification is intended solely for clarity/illustrative purposes, and should not be interpreted as limiting.

An example of a microscope as set forth in the opening paragraph above is a SEM, for instance. Another example is a STEM. In such tools, a relatively narrow charged-particle beam (sometimes called a "probe") is scanned over a presented surface of a specimen, and the employed detector constructs a pixel-by-pixel image of said surface (on the basis of detector output as a function of coordinate position on the surface). To this end, it is conventional to employ a so-called "raster" scan path, whereby, for example:
- An n^{th} scan line is scanned from left to right parallel to (say) the +X direction of a Cartesian coordinate system;
- At the end of this n^{th} scan line, a fast retrace/flyback is made in the -X direction, after which a small incremental step is made in the Y direction;
- Thereafter, an (n+1)^{th} scan line is scanned from left to right parallel to +X;
- And so forth, in consecutive iterations.
However, this approach has disadvantages, *inter alia* since the fast retrace/flyback necessarily incurs a certain overshoot and attendant settling / re-synchronization time (during which the beam is generally blanked), thus causing a throughput penalty. In an attempt to circumvent this problem, one can instead try a (bidirectional) "serpentine" variant of the (unidirectional) raster scan, whereby:
- An n^{th} scan line is scanned from left to right parallel to +X;
- At the end of this n^{th} scan line, a small incremental step is made in the Y direction;
- Thereafter, an (n+1)^{th} scan line is scanned from right to left parallel to -X;
- And so forth, in consecutive iterations.
However, a problem with such a serpentine scan is that, at the end of each scan line, a complete reversal of scan direction is required. Since the scan line is relatively long (*i.e.* has a relatively large amplitude, in that it covers the full width of the scanned surface in the X direction), it provides an opportunity to attain relatively high scan speeds. If direction reversal occurs at such high scan speeds, a relatively large "backlash effect" will ensue, which may, for example, manifest itself as follows:
- If scanning motion is based on magnetic beam deflection (using current-carrying coils), then relatively large and fast voltage excursions will be needed to change the current direction through the employed deflector(s). Such power changes will effectively be rendered impossible by impedance effects (which scale with the rate of voltage/current change) or power supply voltage limitations. To combat this, one might seek to reduce impedance - *e.g.* by using thicker coil wires or employing superconducting coils - but such solutions tend to be (repulsively) cumbersome and expensive and, in any case, will not meaningfully influence the (bottleneck) self-inductance of the deflectors.
- In the case of electrostatic beam deflection (using capacitive plates), relatively large and fast current changes will be needed to alter the voltage on the employed deflector(s). Once again, impedance effects or power supply current limitations effectively disallow such changes in practical situations.
- If scanning motion relies on specimen holder displacement (using mechanical actuators), then relatively large reaction forces / jerks will be entailed in reversing the displacement direction. If untreated, these will lead to parasitic vibrations in the microscope. To prevent this, relatively complex reaction force mitigation mechanisms (such as use of reactive balance masses, compensatory frame actuation, *etc.*) will need to be considered.
As a result of these "backlash" effects - and the relatively unattractive countermeasures needed to mitigate them - one is basically forced to decelerate the line scan gradually to zero velocity before making a direction change. Consequently, a line scan in this instance will generally comprise:
- A pre-scan, accelerative or run-up portion, from velocity zero to velocity v, of length L1;
- A mid-scan, constant-speed portion at velocity v, of length L2;
- A post-scan, decelerative or run-down portion, from velocity *v* to velocity zero, of length L3 (which may or may not be equal to L1).
This scenario is relatively complex and inefficient. In addition, such measures do not address the so-called "zipper effect", which is a (slight) line-to-line misalignment caused by intrinsic beam position delay / data lag issues associated with bidirectional scanning.

Although set-ups such as those set forth in the previous paragraph have produced tolerable results up to now, the current inventors have worked extensively to substantially improve such conventional designs. The results of this endeavor are the subject of the current invention.

It is an object of the invention to provide an improved charged particle microscope as referred to above. In particular, it is an object of the invention that such a microscope should employ an alternative scanning strategy to the raster scan / serpentine scan known from the prior art. Moreover, it is an object of the invention that the improved microscope design should be less susceptible to effects such as the overshoot, settling / re-synchronization, and "backlash" effects described above.

These and other objects are achieved in a method as set forth in the opening paragraph above, characterized in that:
- Said scan pattern comprises a sequence of nested orbital windings about a central point of the pattern;
- A radius of said windings initially changes with a first sign and subsequently changes with a second, opposite sign.
The first and second "signs" (senses, directions) referred to here are (for example, and with no particular preference for a given order) positive/increasing and negative/decreasing. As will be elucidated in more detail below, the radius of the nested windings (circuits, loops, revolutions) may vary continually or discretely. The phrase "central point" should be broadly interpreted as encompassing, for example, a geometrical center, centroid, barycenter, or (elliptical) focus.

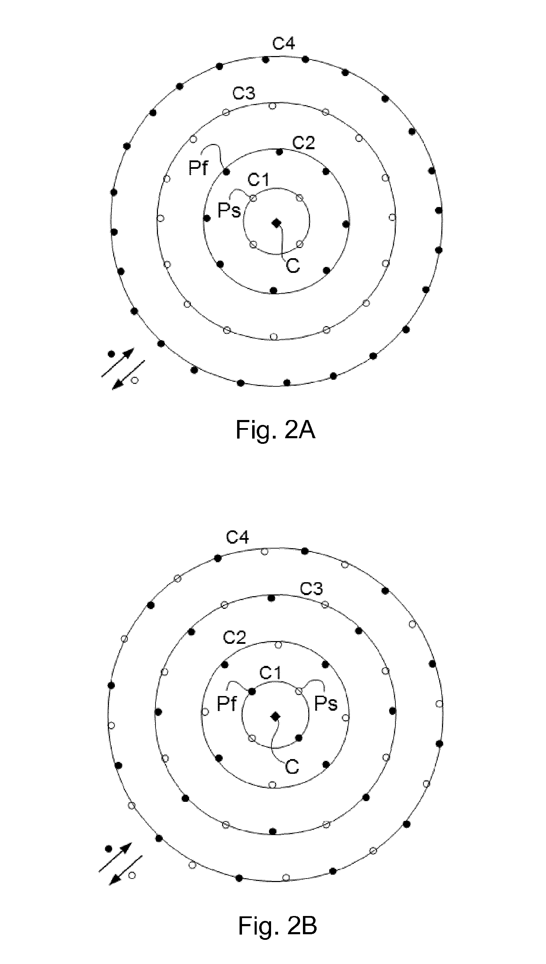

This method according to the invention has a number of significant advantages. For example:
(i) The invention uses a scanning movement strategy that is much smoother than in the prior art. In particular:
   - Each orbital winding can be executed in the *same* tangential direction (*e.g.* clockwise, when viewed along the impinging charged-particle beam).
   - The radius of the windings consistently changes in a *single* direction, before undergoing *just one* direction-change (*e.g.* from increasing to decreasing).
   Consequently, the entire scan pattern can be traversed without the repetitive succession of flyback/backlash movements attendant to the prior art. This greatly reduces overhead / increases throughput, and thus allows the following to be achieved:
   - For a given resolution, one can now attain a higher frame rate; or
   - For a given frame rate, one can now achieve a higher resolution.
   In the prior art, attempting to increase frame rate by decreasing resolution ultimately "hits a wall" because of the bottleneck formed by the abovementioned flyback/backlash overhead; by effectively removing (or at least drastically reducing) this overhead, said "wall" is removed, and one can continue toward higher frame rates by reducing resolution. In fact, in various trials, the inventors have been able to improve frames rates by up to two orders of magnitude relative to conventional scan strategies. This is, for example, of great benefit when imaging specimens that are rapidly changing/moving and, with the current invention, it becomes possible to accurately image specimen changes in a sub-millisecond/microsecond time range.
(ii) When tracing out a scan pattern, there is an inevitable time lag between an intended sampling location (setpoint) and the corresponding actual sampling location (detection point), *e.g.* due to factors such as time-of-flight of charged particles from scan deflectors to the specimen, time-of-flight of emitted radiation (such as secondary electrons) from the specimen to the detector, calculation/conversion processes in the electronic circuitry used to control the data acquisition procedure, *etc.* To correct for this time lag, it must first be converted into a corresponding positional error. In the prior art, this is a difficult task, due to the motional complexities of raster/serpentine scanning strategies (resulting in a complex functional relationship between position and time). However, the much smoother / more uniform scanning motion associated with the current invention renders the corresponding position/time functional relationship much less complicated, thereby greatly facilitating said correction.
(iii) Dividing the inventive scan pattern into two complementary portions (inward and outward orbits) lends itself to so-called "interlacing" whereby, for example, the orbits in one direction are interlaced (interleaved) with the orbits in the opposite direction (see Figure 2A, for example). Such a strategy results in more uniform charging effects in the specimen, resulting in less noticeable charge-related parasitic beam deflection (since a beam that lands symmetrically between two charged rows will tend to suffer less net deflection than a beam that lands asymmetrically beside a single charged row). A similar effect occurs in the case of the "interspersing" illustrated in Figure 2B, for example, which is again made possible by the fact that the inventive scan pattern is "bifurcated" into coupled inward and outward excursions.
(iv) When using a conventional raster/serpentine scan to trace out a rectangular field, the employed X/Y scan deflectors have a greater deflection in the corners of the field than at other locations; consequently, the aberrations/distortions in these corners will be tend to be greater than elsewhere in the field. The current invention allows orbit forms (such as circles) that do not suffer from this problem, because they have a uniform deflection in all directions. Even non-circular orbits (such as ellipses, or "racetrack" / rounded rectangular forms) will suffer less from these effects than conventional rectangles.

A further advantage of the invention is that, by splitting the scan pattern into a paired set of an expanding (widening, outgoing) series of orbits and associated contracting (narrowing, ingoing) series of orbits, one creates the potential for the starting point of the pattern and the finishing point of the pattern to be disposed substantially adjacent to one another (and possibly to exactly coincide). In such an arrangement, the net deflection of the scanning means at the completion of a scan pattern can be essentially the same as it was at the initiation of the scan pattern, which means that the "reset step" necessary to get back to the starting point from the finishing point - so as to scan a subsequent frame - is relatively small (and potentially zero). This again saves time, and thus improves throughput.

As already indicated above, the inventive method allows the radius of successive orbital windings to vary continuously and/or discretely. In an embodiment of the latter case, the sequence of nested orbital windings comprises a set of substantially concentric discrete loops of incrementally different radius. The term "loop" here should be broadly interpreted, and may (for example) comprise a form selected from the group comprising circles, ellipses, ovals and combinations hereof; a particular example of an oval in this context is a so-called "racetrack", which is essentially a rectangle with opposed rounded ends/corners. Along a given orbital winding/loop, sampling points can be located at appropriate (arc/curvilinear) separations, which may, for example, be constant or variable (the latter being the case with so-called "sparse sampling" strategies, for example: see below). Similarly, the radial increment between successive loops may be constant or variable. Importantly, one may embody the inward and outward portions of the scan pattern so that they traverse:
- The same loops on both the inward and outward migrations. In this case, along any given loop, sampling points for the inward migration may, for example, be staggered (interspersed) with sampling points for the outward migration (see Figure 2B, for example);
- A first subset of loops on the outward migration and a second (different) subset of loops on the inward migration. In a particular embodiment, these first and second subsets may be interlaced/interleaved, for instance (as in Figure 2A, for example). One could, of course, also opt for a hybrid strategy that is a mix of the two approaches set forth above.

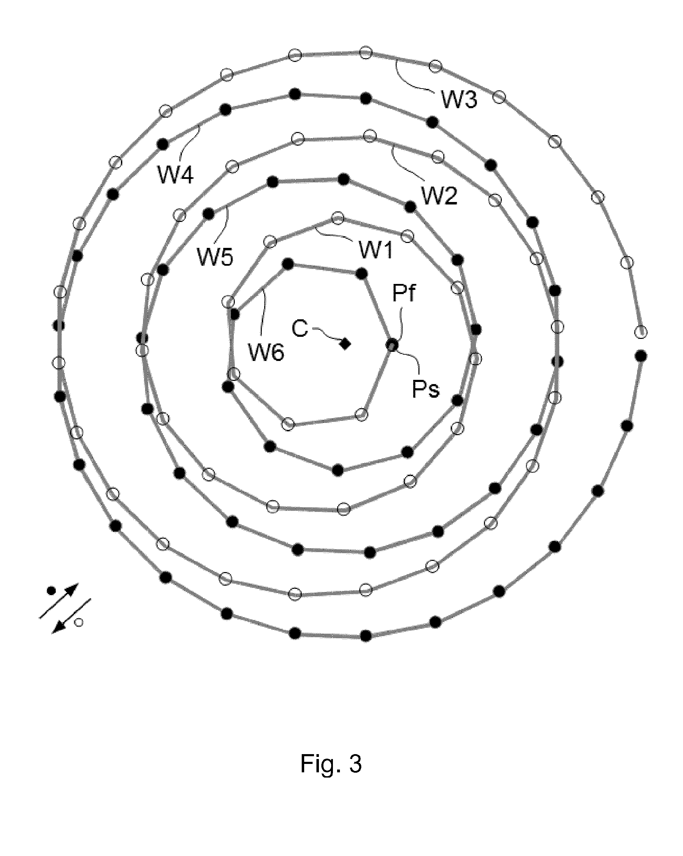

In an alternative embodiment of the invention, the sequence of nested orbital windings comprises a spiral path of continuously changing radius. An individual "winding" can be defined in this case as a single revolution through θ = 2π in an (R,θ) polar coordinate system (centered on the "central point" of the windings), whereby R will change along the course of the winding (similar, for example, to the orbits made by a conical pendulum when motional energy is subtracted from / added to the pendulum). In a particular embodiment, one could, for example, start at said central point, spiral/coil outward (in multiple revolutions) to a peripheral point, and then spiral/coil back inward again toward/to said central point. In somewhat of an analogy to the different situations set forth in the previous paragraph, the windings of the contracting spiral may or may not (roughly) coincide with those of the expanding spiral, according to choice; in particular, the windings of one spiral may be (at least partially) interlaced/interleaved with those of the other, if desired. See, for example, Figure 3.

In a particular embodiment of the present invention, the scan pattern is sparsely populated by sampling points. So-called "sparse scanning" is a technique whereby, instead of visiting/sampling all possible pixel (box/cell) positions along a scan path (orbital winding), one instead only visits a relatively sparse set of such positions (by skipping over certain intermediates). Such a scanning technique (also referred to as "compressive sensing") is advantageous in that it is necessarily (much) faster than a full scan, and entails much less radiation exposure of the specimen. More information on (diverse) sparse scanning techniques in CPM imaging can, for example, be gleaned from co-pending European Patent Application EP15172227.9.

Some additional aspects of the invention deserve mention here:
(a) As already set forth above, the method according to the invention is capable of achieving very high frame rates. In such instances, instead of passing each individual frame to a display device being used by the microscope operator, one may instead elect (so as to reduce processing/display overhead) to bundle successive frames together into "batches" (*e.g.* of 10 or 100 frames each), and to pass filtered (or averaged) versions of these batches to said display device. The raw data can, of course, be stored without such bundling / filtering. An example of filtering in this context is Temporal Median Filtering, for instance, which is *(inter alia*) a useful technique for addressing so-called "salt-and-pepper noise" that can manifest itself at low dwelling times / high frame rates - see, for example, the following references:
   https://en.wikipedia.org/wiki/Median_filter
   https://en.wikipedia.org/wiki/Salt-and-pepper_noise
   In addition, one might, for example, consider applying a bandwidth correction filter, so as to better match a (relatively slow) response time of the employed detector to a higher data rate.
(b) Since typical display devices (such as Flat Panel Displays and Cathode Ray Tubes) construct images using a raster scan, the orbital data acquisition of the present invention may need to be "processed" before being rendered visible on such displays. Such processing may, for example, make use of bi-linear interpolation, which allows data conversion substantially without parasitic Moire effects. The processing entailed can, for example, be performed offline on raw stored data; alternatively, it can be performed on-the-fly, *e.g.* if only a specific frame is to be visualized.
(c) Just because the scan pattern traced out in the invention is orbital in form does not mean that it has to be traced out by scanning means with intrinsically "polar" (rotary-radial) degrees of freedom. Since it is possible to express the locus of a circle or spiral (for instance) in Cartesian coordinates, it is correspondingly possible to trace out such loci using (combined/synchronized motions produced by) linear X/Y deflectors/actuators.

The invention will now be elucidated in more detail on the basis of exemplary embodiments and the accompanying schematic drawings, in which:
Figure 1 renders a cross-sectional view of an embodiment of a scanning-type charged particle microscope in which the present invention can be implemented.
Figures 2A, 2B shows various aspects of a scan pattern traced out using a particular embodiment of the current invention (circular traces).
Figure 3 shows various aspects of a scan pattern traced out using an alternative embodiment of the current invention (spiral traces).

In the Figures, where pertinent, corresponding parts may be indicated using corresponding reference symbols.

### Embodiment 1

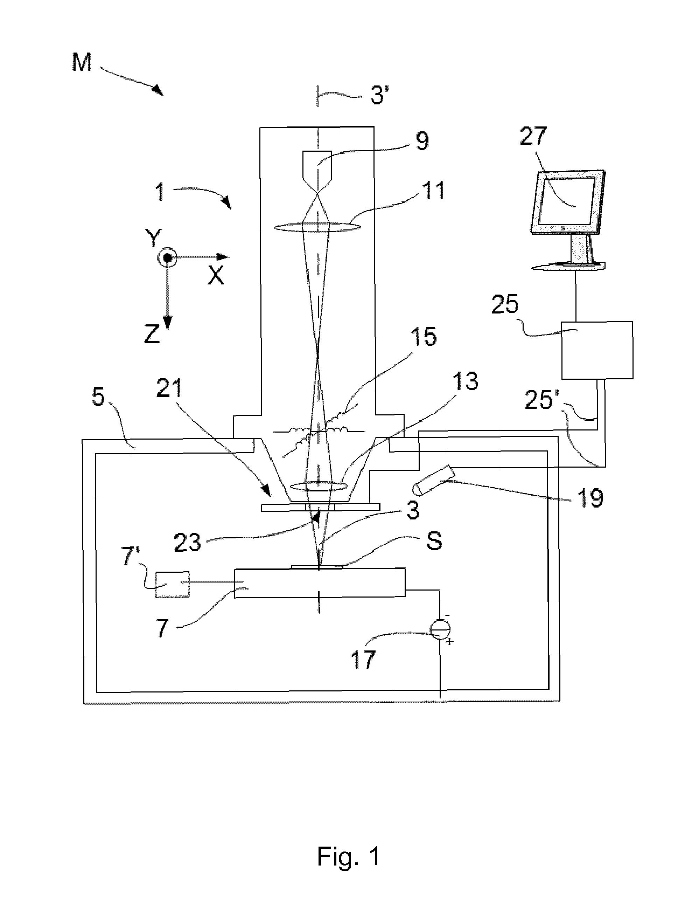

Figure 1 is a highly schematic depiction of an embodiment of a CPM according to the present invention; more specifically, it shows an embodiment of a scanning-type microscope M, which, in this case, is a SEM (though, in the context of the current invention, it could just as validly be an ion-based microscope, for example). The microscope M comprises a particle-optical column / illuminator 1, which produces a beam 3 of input charged particles (in this case, an electron beam) that propagates along a particle-optical axis 3'. The particle-optical column 1 is mounted on a vacuum chamber 5, which comprises a specimen holder 7 and associated stage/actuator 7' for holding/positioning a specimen S. The vacuum chamber 5 is evacuated using vacuum pumps (not depicted). With the aid of voltage source 17, the specimen holder 7, or at least the specimen S, may, if desired, be biased (floated) to an electrical potential with respect to ground.

The particle-optical column 1 comprises an electron source 9 (such as a Schottky gun, for example), lenses 11, 13 to focus the electron beam 3 onto the specimen S, and a deflection unit 15 (to perform beam steering / scanning of the beam 3). The apparatus M further comprises a controller / computer processing apparatus 25 for controlling *inter alia* the deflection unit 15, lenses 11, 13 and detectors 19, 21, and displaying information gathered from the detectors 19, 21 on a display unit 27.

The detectors 19, 21 are chosen from a variety of possible detector types that can be used to examine different types of output radiation flux emanating from the specimen S in response to irradiation by the input beam 3. In the apparatus depicted here, the following (non-limiting) detector choices have been made:
- Detector 19 is an Everhardt-Thornley detector that is used to detect (at least a portion of) an output flux of secondary electrons emanating from the specimen S;
- Detector 21 is a segmented silicon electron detector, comprising a plurality of independent detection segments (*e.g.* quadrants) disposed about a central aperture 23 (allowing passage of the beam 3). Such a detector can, for example, be used to investigate the angular dependence of a flux of output (secondary or backscattered) electrons emerging from the specimen S.
As here rendered, both detectors 19 and 21 are used to examine electrons; however, this is purely a design/implementation choice and, if desired, one could also elect to detect other types of output radiation flux emanating from the specimen S (*e.g.* X-rays, cathodoluminescence) in addition, or as an alternative, to electrons.

By scanning the input beam 3 over the specimen S, output radiation - comprising, for example, a flux of X-rays, infrared/visible/ultraviolet light, secondary electrons and/or backscattered (BS) electrons - emanates from the specimen S. Since such output radiation is position-sensitive (due to said scanning motion), the information obtained from the detectors 19, 21 will also be position-dependent. This fact allows the output of detector 19 (for instance) to be used to produce (for example) a secondary electron image of (part of) the specimen S, which image is basically a map of an output of detector 19 as a function of scan-path position on the specimen S.

The signals from the detectors 19, 21 pass along control lines (buses) 25', are processed by the controller 25, and displayed on display unit 27. Such processing may include operations such as combining, integrating, subtracting, false colouring, edge enhancing, and other processing known to the skilled artisan. In addition, automated recognition processes (*e.g.* as used for particle analysis) may be included in such processing.

It should be noted that many refinements and alternatives of such a set-up will be known to the skilled artisan, including, but not limited to:
- The use of dual beams - for example an electron beam 3 for imaging and an ion beam for machining (or, in some cases, imaging) the specimen S;
- The use of a controlled environment at the specimen S - for example, maintaining a pressure of several mbar (as used in a so-called Environmental SEM) or by admitting gases, such as etching or precursor gases,
*etc.* Although the scanning-type microscope shown in Figure 1 is a SEM, it could, in the context of the current invention, just as validly be a STEM, for example; in that case, a further particle-optical column (projection system; not depicted) will be located below the specimen S, to capture radiation transmitted through the specimen S during scanning and direct it onto a STEM detector (not depicted).

The current invention concerns the manner in which the beam 3 is scanned with respect to the specimen S, which is held on holder 7 so as to show a presented surface to the beam 3. As already discussed above, relative scanning motion of beam 3 and holder 7 can, in principle, be achieved in two different ways, namely:
- By using deflection unit 15 to move the beam 3 relative to the holder 7; and/or
- By using stage /actuator 7' to move the holder 7 relative to the beam 3.
To this end, the controller 25 can calculate and issue periodic setpoints to the (long-stroke / short-stroke) scanning means 15 and/or 7' based on coordinate positions of sampling points on a particular reference pattern that it desires to use as (a basis for) the ultimate scan path. Regardless of the scan mechanism used, the current invention differs from the prior art as regards the type of scan pattern traced out by the beam 3 on the presented surface of the specimen S; more specifically, unlike the intrinsically linear, repetitive, back-and-forth ("Cartesian") motion intrinsic to the raster/serpentine scanning patterns of the prior art, the current invention uses a smoother, orbital ("Polar") motion with essentially just one direction reversal - from an expanding to a contracting orbital series (or *vice versa*) at a "halfway point" (inversion/inflexion point) of the scan motion. Some specific (non-limiting) examples of such motion will be discussed in the following Embodiments.

### Embodiment 2

Figures 2A, 2B shows various aspects of a scan pattern traced out using a particular embodiment of the current invention. In both cases, the depicted scan pattern is embodied such that:
- It comprises a sequence of nested orbital windings about a central point C [◆] of the pattern. In this case, these windings take the form of closed loops C1, C2, C3, C4, which are here depicted as circles (but could also be ellipses or ovals, for example).
- A radius of successive windings C1, C2, C3, C4 initially changes with a first sign (increases) and subsequently changes with a second, opposite sign (decreases).
Both Figures show sampling points disposed on the windings C1, C2, C3, C4, which take the form of:
- Open (white) [○] circles for outwardly increasing/expanding orbits;
- Filled (black) [●] circles for inwardly decreasing/contracting orbits.
For simplicity, and to avoid cluttering, only four orbits/windings C1, C2, C3, C4 are shown in each Figure; however, one may, of course, choose to use a greater (or lesser) number of orbits if so desired.
In Figure 2A:
- Orbit C1 is filled with its entire allotment of sampling points [○], before moving *outward* to orbit C3, which is also filled with its entire allotment of sampling points [○]. The arc spacing (arc length, curve length) between neighboring sampling points is approximately constant (though this does not necessarily have to be the case).
- Orbit C4 is similarly filled with its entire allotment of sampling points [●], before moving *inward* to orbit C2, which is also filled with its entire allotment of sampling points [●]. Orbit C4 can be reached from orbit C3 by making a "half step" outward.
This is an example of interlacing/interleaving since, for example, inward orbits C4 and C2 straddle outward orbit C3, which is therefore interleaved/interposed between C4 and C2. Note that a starting point Ps and finishing point Pf of the scan pattern are adjacent/close to one another.
In contrast, in Figure 2B:
- Each of orbits C1, C2, C3, C4 gets a half-allotment of sampling points [○] during the *outward* sequence/migration of orbits. The arc spacing between neighboring sampling points is approximately twice as large as in Figure 2A.
- Thereafter, each of orbits C1, C2, C3,C4 gets its remaining half-allotment of sampling points [●] during the *inward* sequence of orbits. Once again, the arc spacing between neighboring sampling points is approximately twice as large as in Figure 2A. As here depicted, these "inward" sampling points [●] are set down with an approximate 50/50 duty cycle relative to the aforementioned "outward" sampling points [○], so as to alternate symmetrically therewith along the course of a given orbit; this, however, does not have to be the case, and one could alternatively choose a different (and even irregular) duty cycle, if desired.
This is an example of interspersing. Note again that a starting point Ps and finishing point Pf of the scan pattern are adjacent/close to one another.
In a non-limiting example (relevant to Figure 2A and/or 2B), one could, for instance, use a cardinality of about 30 (substantially equally spaced) orbits, with a smallest (starting) radius of about 10 nm, a largest (finishing) radius of about 300 nm, and an arc length between (ultimate) neighboring sampling points of about 10 nm. These figures are quoted as a rough indication only, and the skilled artisan will be able to choose his own values to suit a given situation.

### Embodiment 3

Figure 3 shows various aspects of a scan pattern traced out using a different embodiment of the current invention. It shows certain similarities to Figures 2A and 2B, but also differs from them, principally in that:
- The depicted scan pattern is now *spiral* in nature; consequently, its radius (distance from central point C [◆]) changes continuously rather than demonstrating the discrete (step-like) changes in Figures 2A and 2B.
- The pattern comprises three (open) outward spiral windings W1, W2, W3 (all with sampling points [○]), followed by three (open) inward spiral windings W4, W5, W6 (all with sampling points [●]).
Note that a starting point Ps and finishing point Pf of the scan pattern can be chosen so as to exactly coincide (or, at least, be close/adjacent to one another).

It should be explicitly noted that, in the examples given in Embodiments 2 and 3, instead of first migrating outward and then inward, one could instead first migrate inward and then outward. This is a matter of choice.

## Claims

1. A method of using a scanning-type Charged Particle Microscope, comprising the following steps:
- Providing a specimen on a specimen holder;
- Directing a beam of charged particles from a source through an illuminator so as to irradiate the specimen;
- Using a detector to detect a flux of radiation emanating from the specimen in response to said irradiation;
- Using scanning means to produce relative scanning motion of the beam and specimen so as to cause the beam to trace out a scan pattern on the specimen,
**characterized in that**:
- Said scan pattern comprises a sequence of nested orbital windings about a central point of the pattern;
- A radius of said windings initially changes with a first sign and subsequently changes with a second, opposite sign.

2. A method according to claim 1, whereby a starting point of the pattern and a finishing point of the pattern are substantially adjacent to one another.

3. A method according to claim 1 or 2, wherein said sequence comprises a set of substantially concentric discrete loops of incrementally different radius.

4. A method according to claim 3, wherein said loops are selected from the group comprising circles, ellipses, ovals and combinations hereof.

5. A method according to claim 1 or 2, wherein said sequence comprises a spiral path of continuously changing radius.

6. A method according to any of claims 1-5, wherein:
- For a first subset of sampling points disposed on said pattern while said radius is changing with said first sign; and
- For a second subset of sampling points disposed on said pattern while said radius is changing with said second sign,
at least one of the following arrangements applies:
- With reference to two successive windings, one of these windings will comprise only sampling points from said first subset, and the other of these windings will comprise only sampling points from said second subset;
- Along a course of a given winding, sampling points from said second subset are alternated with sampling points from said first subset.

7. A scanning-type Charged Particle Microscope, comprising:
- A specimen holder, for holding a specimen;
- A source, for producing a beam of charged particles;
- An illuminator, for directing said beam so as to irradiate the specimen;
- A detector, for detecting a flux of radiation emanating from the specimen in response to said irradiation;
- Scanning means, for producing relative scanning motion of the beam and specimen so as to cause the beam to trace out a scan pattern on the specimen;
- A programmable controller that can be invoked to execute at least one automated procedure in the microscope,
**characterized in that** said controller is adapted to control said scanning means such that:
- Said scan pattern comprises a sequence of nested orbital windings about a central point of the pattern;
- A radius of said windings initially changes with a first sign and subsequently changes with a second, opposite sign.
